# EUROPÄISCHE PATENTSCHRIFT

(11) **EP 1 252 706 B1**
(45) Veröffentlichungstag und Bekanntmachung des Hinweises auf die Patenterteilung: **22.09.2004**
(21) Anmeldenummer: 00991099.3
(22) Anmeldetag: 19.12.2000
(51) Int. Cl.: H03B 5/12, H03D 7/14

(54) **OSZILLATOR-/MISCHERSCHALTUNG**
OSCILLATOR/MIXER CIRCUIT
CIRCUIT OSCILLATEUR/MELANGEUR

(30) Priorität: 20.12.1999 DE 19961534
(43) Veröffentlichungstag der Anmeldung: 30.10.2002
(73) Patentinhaber: Infineon Technologies AG, 81669 München (DE)
(72) Erfinder: SEWALD, Dieter, 9434 Au/SG (CH)
(74) Vertreter: Dokter, Eric-Michael
(86) Internationale Anmeldenummer: PCT/DE2000/004523
(87) Internationale Veröffentlichungsnummer: WO 2001/047101

(56) Entgegenhaltungen:
- US-A- 5 166 645

## Beschreibung

Die Erfindung betrifft eine Oszillator-/Mischerschaltung.

Eine solche Oszillator-/Mischerschaltung zur Verarbeitung von analogen Signalen ist als eine Serienschaltung einer Oszillatorschaltung mit einer Mischerschaltung bekannt.

Ein spannungsgesteuerter Oszillator (Voltage Controlled Oscillator) dient in der analogen Schaltungstechnik zur Erzeugung eines Signals einer durch Dimensionierung der Oszillatorschaltung vorgegebenen Frequenz. Mittels einer Mischerschaltung, insbesondere eines Schaltmischers, wie beispielsweise einer Gilbertzelle, wird ein zu mischendes Signal mit einem Lokaloszillatorsignal, wie im Weiteren näher erläutert wird, gemischt, d.h. es wird eine Frequenzumsetzung des zu mischenden Signals durchgeführt.

Sowohl ein spannungsgesteuerter Oszillator als auch ein Schaltmischer werden in einer mikroelektronischen Schaltung derzeit in einer Vielzahl von Geräten und Systemen verwendet, beispielsweise zur drahtlosen Funkübertragung von Informationen, wie beispielsweise in einem Mobilfunksystem, einem GPS-Empfänger sowie einem Fernseh-Satellitenempfänger. Eine solche Oszillator- /Mischerschaltung ist z.B. aus US-A-5 166 645 bekannt.

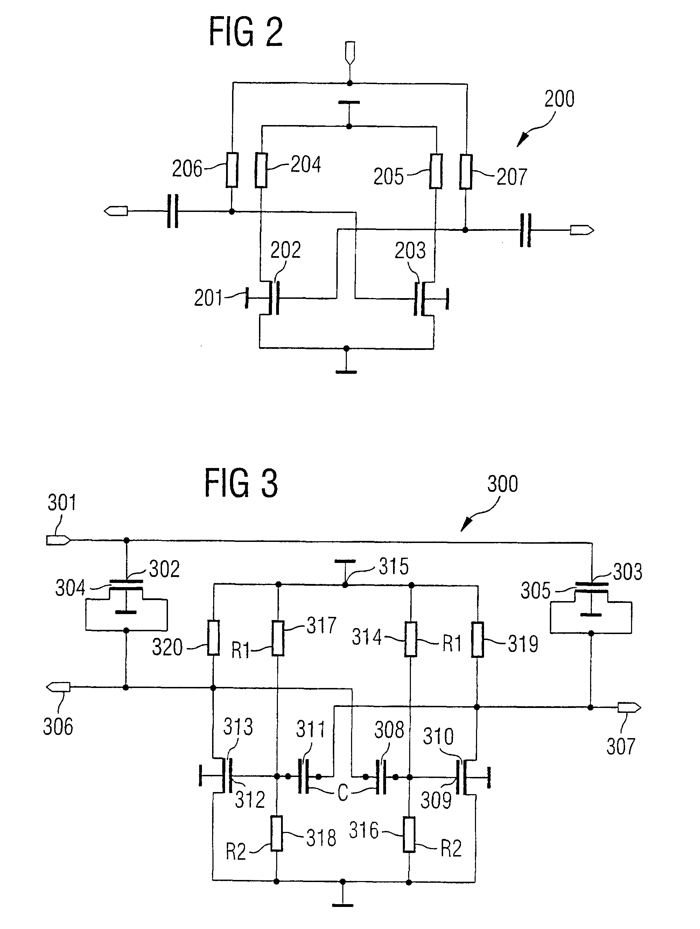

**Fig.2** zeigt den prinzipiellen Aufbau eines üblichen Oszillators 200, wie er in der Mikroelektronik eingesetzt wird.

Der Oszillator 200 weist eine differentielle Kippstufe 201 mit zwei MOS-Feldeffekttransistoren 202, 203 auf. Weiterhin weist der in **Fig.2** dargestellte Oszillator 200 ein Resonatorelement 204, 205 sowie wenigstens ein spannungsgesteuertes Abstimmelement 206, 207 auf. Das spannungsgesteuerte Abstimmelement 206, 207 wird auch als Tuningelement bezeichnet.

**Fig.3** zeigt eine Prinzipschaltung eines Oszillators gemäß dem Stand der Technik.

Der Oszillator 300 ist als RC-Oszillator ausgestaltet und weist zwei mit einem Eingang 301 über ihren jeweiligen Gate-Anschluss 302, 303 gekoppelte MOS-Feldeffekttransistoren 304, 305 auf. Der Source-Anschluss und der Drain-Anschluss des ersten MOS-Feldeffekttransistors 304 sind zusammengeschaltet und mit einem ersten Ausgang 306 gekoppelt. Der Drain-Anschluss und der Source-Anschluss des zweiten MOS-Feldeffekttransistors 305 sind ebenfalls miteinander sowie mit einem zweiten Ausgang 307 des Oszillators 300 gekoppelt.

Über einen ersten Kondensator C 308 ist der erste Ausgang 306 mit dem Gate-Anschluss 309 eines dritten Transistors 310 gekoppelt.

Der zweite Ausgang 307 ist über einen zweiten Kondensator C 311 mit dem Gate-Anschluss 312 eines vierten Transistors 313 gekoppelt.

Der Gate-Anschluss 309 des dritten Transistors 310 ist ferner über einen ersten elektrischen Widerstand R1 314 mit dem Versorgungsanschluss 315, an den die Betriebsspannung V_{DD} der Oszillatorschaltung 300 anlegbar ist, gekoppelt. Weiterhin ist der Gate-Anschluss 309 des dritten Transistors 310 über einen zweiten elektrischen Widerstand R2 316 mit dem Massepotential gekoppelt, wodurch der Arbeitspunkt der Oszillatorschaltung 300 eingestellt werden kann.

Der Gate-Anschluss 312 des vierten Transistors 313 ist über einen dritten elektrischen Widerstand R1 317 mit dem Versorgungsanschluss 315 sowie über einen vierten elektrischen Widerstand 318 ebenfalls mit dem Massepotential verbunden.

Weiterhin sind der Drain-Anschluss des dritten Transistors 310 über einen fünften elektrischen Widerstand 319 und der Drain-Anschluss des vierten Transistors 313 über einen sechsten elektrischen Widerstand 320 mit dem Versorgungsanschluss 315 gekoppelt. Der fünfte elektrische Widerstand 319 und der sechste elektrische Widerstand 320 sind Lastwiderstände.

Ferner sind die Source-Anschlüsse des dritten Transistors 310 und des vierten Transistors 313 mit dem Massepotential gekoppelt.

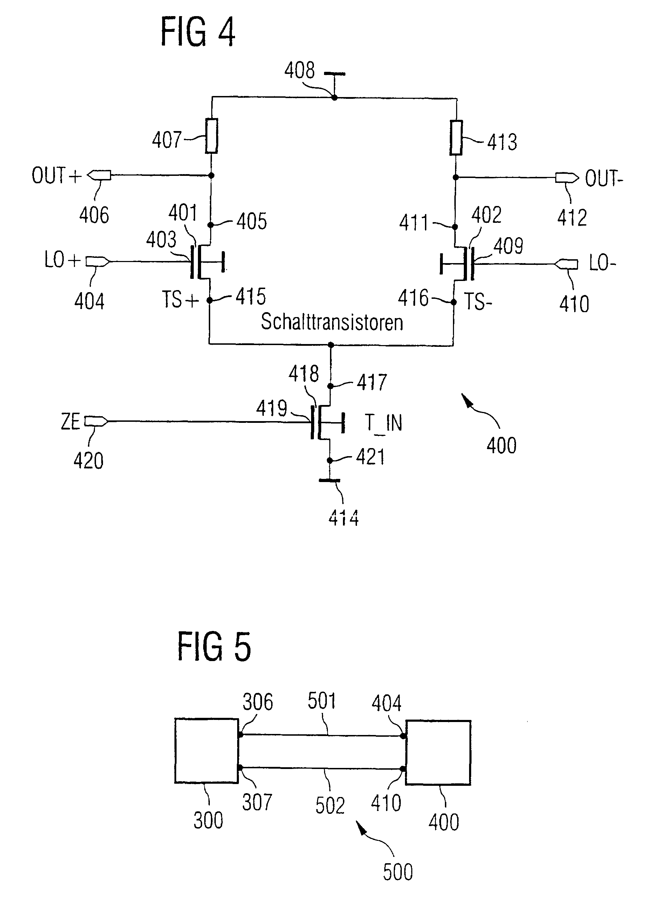

**Fig.4** zeigt den Aufbau einer üblichen Gilbertzelle 400, die ein Beispiel ist für einen Schaltmischer, d.h. für eine Mischerschaltung, die, wie im Weiteren beschrieben wird, zwei Transistoren, allgemein zwei Schalterelemente aufweist, die jeweils betrieben werden, indem die Transistoren eingeschalten und ausgeschalten werden. Weiterhin weist die übliche Gilbertzelle 400 einen analogen Eingangstransistor auf.

Die Gilbertzelle 400 weist einen ersten Schalttransistor 401 sowie einen zweiten Schalttransistor 402 auf.

Der Gate-Anschluss 403 des ersten Schalttransistors ist mit einem ersten Lokaloszillatoreingang 404 gekoppelt. An den ersten Lokaloszillatoreingang 404 wird ein erstes Lokaloszillatorsignal LO+ angelegt und somit an den Gate-Anschluss 403 des ersten Schalttransistors 401, um diesen mittels des Lokaloszillatorsignals LO+ zu steuern, d.h. einzuschalten und auszuschalten.

Der Drain-Anschluss 405 des ersten Schalttransistors 401 ist mit einem ersten Ausgang 406 gekoppelt. Ferner ist der Drain-Anschluss 405 des ersten Schalttransistors 401 über einen ersten elektrischen Widerstand 407 als Mischerlastwiderstand mit einem Versorgungsanschluss 408 gekoppelt. An dem Versorgungsanschluss 408 ist die Betriebsspannung V_{DD} zum Betrieb der Mischerschaltung 400 anlegbar.

An den Gate-Anschluss 409 des zweiten Schalttransistors 402 ist ein zweiter Lokaloszillatoranschluss 410 angeschlossen, an welchen ein zweites Lokaloszillatorsignal LO- anlegbar ist zum Steuern des zweiten Schalttransistors 402. Das zweite Lokaloszillatorsignal LO- ist gegenüber dem ersten Lokaloszillatorsignal LO+ um 180° verschoben.

Der Drain-Anschluss 411 des zweiten Schalttransistors 409 ist mit einem zweiten Ausgang 412 gekoppelt sowie über einen zweiten elektrischen Widerstand 413 als Mischerlastwiderstand mit dem Versorgungsanschluss 408.

Die Source-Anschlüsse 414, 415 des ersten Schalttransistors 401 sowie des zweiten Schalttransistors 402 sind mit dem Drain-Anschluss 417 eines analogen Eingangstransistors 418 gekoppelt. Der Gate-Anschluss 419 des Eingangstransistors 418 ist mit einem Mischsignaleingang 420 gekoppelt, an dem das zu mischende analoge Eingangssignal ZE anlegbar ist. Der Source-Anschluss 421 des Eingangstransistors 418 ist mit dem Massepotential gekoppelt.

Um eine Oszillator-/Mischerschaltung aus den oben beschriebenen bekannten Schaltungen, d.h. der Oszillatorschaltung 300 sowie der Mischerschaltung 400 zu bilden, ist es bekannt, diese hintereinander zu schalten, d.h. eine bekannte Oszillator-/Mischerschaltung 500 (vgl. **Fig.5**) weist die in **Fig.3** beschriebene Oszillatorschaltung 300 sowie die in **Fig.4** beschriebenen Mischerschaltung 400 auf, die miteinander in Serie geschaltet sind derart, dass der erste Ausgang 306 des Oszillators 300 über eine erste elektrische Verbindung 501 mit dem ersten Lokaloszillatoreingang 404 der Mischerschaltung 400 gekoppelt ist. Der zweite Ausgang 307 der Oszillatorschaltung 300 ist über eine zweite elektrische Koppelung 502 mit dem zweiten Lokaloszillatoreingang 410 der Mischerschaltung 400 gekoppelt. Die Lokaloszillatorsignale sind gegeneinander um 180° verschoben.

Die bekannte Oszillator-/Mischerschaltung 500 weist eine Mehrzahl von Nachteilen auf.
- Durch die Serienschaltung zweier vollständiger, im Wesentlichen voneinander unabhängiger Schaltungen, d.h. der Oszillatorschaltung 300 und der Mischerschaltung 400, wird eine relativ große Anzahl von elektrischen Bauelementen, d.h. eine relativ große Anzahl elektrischer Widerstände sowie Transistoren, üblicherweise MOS-Feldeffekttransistoren, benötigt. Bei der Integration der bekannten Oszillator-/Mischerschaltung 500 auf einem Chip besteht somit ein erheblicher Bedarf an Chipfläche zu deren Realisierung.
- Ferner ist ein erheblicher Nachteil der Oszillator-/Mischerschaltung 500 darin zu sehen, dass zwischen den Schaltungskomponenten, d.h. der Oszillatorschaltung 300 und der Mischerschaltung 400 zwei elektrische Verbindungen 501, 502 erforderlich sind. Insbesondere im Bereich der Höchstfrequenzanwendungen stellen die elektrischen Verbindungen 501, 502 eine erhebliche Einschränkung hinsichtlich ihrer Verwendbarkeit dar aufgrund der sehr starken Dämpfung, der das an den Ausgängen 306, 307 der Oszillatorschaltung anliegende Ausgangssignal unterliegt, bis es zu den Eingängen 404, 410 der Mischerschaltung 400 gelangt. Bei einer Höchstfrequenzanwendung, bei der eine Signalfrequenz in einem Bereich von ungefähr 1Ghz bis zu mehreren zehn GHz, vorzugsweise bis zu 77 GHz und höher benötigt wird, führt das dazu, dass eine solche Oszillator-/Mischerschaltung 500 kaum einsetzbar ist, da kein Signal mit ausreichender Signalamplitude an den Lokaloszillatoreingängen 404, 410 der Mischerschaltung 400 anliegt, d.h. ankommt.
- Ferner ist insbesondere im Rahmen der Realisierung der Oszillator-/Mischerschaltung 500 als integrierte Schaltung aufgrund der räumlichen Abstände der einzelnen Bauelemente der Schaltung das sogenannte Matching-Problem von erheblicher Bedeutung, da es technologisch ein erhebliches Problem darstellt, die zu verwendenden Bauelemente ausreichend gleichartig zu fertigen über einen größeren Abstand voneinander auf einem Chip bzw. auf einem Wafer. Damit sind die Bauelemente häufig nur sehr schwer und manchmal sogar gar nicht aufeinander abgestimmt, was zu einer nur schlecht bis überhaupt nicht funktionierenden Oszillator-/Mischerschaltung 500 führt.

Weiterhin ist es bekannt, eine Diode bzw. eine eine Diode aufweisende elektrische Schaltung als Mischerschaltung oder als Oszillatorschaltung einzusetzen, wobei in einem solchen Fall, bei dem das Mischen einer Mischerschaltung auf einem aktiven Bauelement beruht, das Mischen der zu mischenden Signale auf der nicht-linearen Kennlinie eines aktiven Bauelements, im speziellen Fall der Diode, beruht.

Somit liegt der Erfindung das Problem zugrunde, eine Oszillator-/Mischerschaltung anzugeben, die einen gegenüber der bekannten Oszillator-/Mischerschaltung reduzierten Flächenbedarf bei deren Realisierung auf einem Chip aufweist und bei der die Mischerschaltung der Oszillator-/Mischerschaltung nicht auf der Nutzung der nicht-linearen Kennlinie eines aktiven Bauelements beruht.

Das Problem wird durch die Oszillator-/Mischerschaltung mit den Merkmalen des unabhängigen Patentanspruchs gelöst.

Die Oszillator-/Mischerschaltung weist eine Oszillatorschaltung sowie eine Mischerschaltung auf. Die Oszillatorschaltung und die Mischerschaltung weisen teilweise dieselben Bauelemente auf.

In anderen Worten ausgedrückt bedeutet dies, dass dieselben Bauelemente der Oszillator-/Mischerschaltung sowohl zur Frequenzerzeugung als auch für den Mischvorgang verwendet werden.

Weiterhin weist die Mischerschaltung mindestens ein erstes Schalterelement und ein zweites Schalterelement auf, wobei ein Ausgang des ersten Schalterelements über ein erstes Rückkopplungselement mit einem Steuereingang des zweiten Schalterelements gekoppelt ist. Ein Ausgang des zweiten Schalterelements ist über ein zweites Rückkopplungselement mit einem Steuereingang des ersten Schalterelements gekoppelt. Die Rückkopplungselemente sind derart eingerichtet, dass ein Oszillatorbetrieb der Oszillator-/Mischerschaltung ermöglicht ist.

Der Oszillatorbetrieb der Oszillator-/Mischerschaltung wird beispielsweise dadurch gewährleistet, dass ein Anschwingen der Oszillatorschaltung in der Oszillator-/Mischerschaltung gewährleistet wird, was beispielsweise dadurch erreicht werden kann, dass die Rückkopplungselemente gewährleisten, dass eine für die jeweilige Schaltungsart der Oszillatorschaltung geeignete Phasenlage der an den Steuereingängen der Schalterelemente anliegenden Steuersignale gewährleistet ist sowie eine Schleifenverstärkung von größer als 1.

Anschaulich ausgedruckt bedeutet dies, dass die Oszillator-/Mischerschaltung eine Oszillatorschaltung sowie eine Mischerschaltung aufweist, die gemeinsame Bauelemente aufweisen und bei der die Mischerelemente als ein Schaltmischer, d.h. als ein üblicherweise mindestens zwei Transistoren aufweisende Schaltung realisiert ist, die im Einschaltbetrieb und Ausschaltbetrieb betrieben werden.

Auf diese Weise wird gewährleistet, dass das Mischen von Signalen in der Oszillator-/Mischerschaltung nicht auf einer nicht-linearen Kennlinie eines aktiven Bauelements basiert.

Die Oszillatorschaltung kann auch als LC-Oszillatorschaltung eingerichtet sein.

In diesem Fall ist es gemäß einer Ausgestaltung der Erfindung vorgesehen, dass an dem Ausgang des ersten Schalterelements und an dem Ausgang des zweiten Schalterelements jeweils eine Induktivität gekoppelt ist und der Eingang des ersten Schalterelements mit dem Eingang des zweiten Schalterelements sowie mit einem Mischsignaleingang, an dem ein zu mischendes Signal anlegbar ist, gekoppelt ist.

Anschaulich kann die Oszillator-/Mischerschaltung somit als eine Oszillatorschaltung angesehen werden, bei denen zwischen dem Masseanschluss und den Source-Anschlüsse der Schwingtransistoren der Oszillatorschaltung ein Eingangstransistor geschaltet ist, dessen Gate-Anschluss mit dem Mischsignaleingang gekoppelt ist. Allgemein ist zwischen die Drain-Anschlüsse der Schwingtransistoren und dem Masseanschluss ein Eingangstransistor geschaltet, dessen Steuereingang mit dem Mischsignaleingang gekoppelt ist.

Somit ist eine Oszillator-/Mischerschaltung bereitgestellt, die eine erheblich reduzierte Anzahl an benötigten Bauelementen aufweist und die gleichzeitig als Oszillatorschaltung und als Mischerschaltung betrieben werden kann.

Durch den kompakten Aufbau und die teilweise gemeinsame Nutzung einiger Bauelemente sowohl durch die Oszillatorschaltung als auch durch die Mischerschaltung in der Oszillator-/Mischerschaltung wird eine erhebliche Reduzierung an benötigter Chipfläche bei der Integration der Oszillator-/Mischerschaltung erreicht.

Ferner ist die Oszillator-/Mischerschaltung aufgrund ihrer kompakten Bauweise sehr gut insbesondere für eine Hochfrequenzanwendung geeignet, da die zu verarbeitenden Signale erheblich verringerte Entfernungen über elektrische Leitungen verglichen mit der oben beschriebenen bekannten Oszillator-/Mischerschaltung zurücklegen müssen und somit einer erheblich verringerten Dämpfung unterliegen.

Auch wird das Matching-Problem der verwendeten Bauelemente vermieden.

Gemäß einer Ausgestaltung der Erfindung ist es vorgesehen, zwischen die Eingänge der Schalterelemente und den Mischsignaleingang einen analogen Eingangstransistor zu schalten, wobei der Mischsignaleingang mit dem Steuereingang des Eingangstransistors gekoppelt ist.

Gemäß einer alternativen Ausgestaltung der Erfindung ist es ferner vorgesehen, die Oszillatorschaltung als eine RC-Oszillatorschaltung auszubilden.

Gemäß dieser Ausgestaltung ist ferner ein erster elektrischer Widerstand vorgesehen, der zwischen den Steuereingang des ersten Schalterelements und einen Versorgungsanschluss geschaltet ist, an welchem Versorgungsanschluss eine Betriebsspannung V_{DD} der Oszillator-/Mischerschaltung anlegbar ist. Ein zweiter elektrischer Widerstand ist zwischen den Steuereingang des ersten Schalterelements und den Eingang des ersten Schalterelements geschaltet und ein dritter elektrischer Widerstand ist zwischen den Steuereingang des zweiten Schalterelements und den Versorgungsanschluss geschaltet. Ein vierter elektrischer Widerstand ist zwischen den Steuereingang des zweiten Schalterelements und den Eingang des zweiten Schalterelements geschaltet. Ferner ist gemäß dieser Ausgestaltung der Erfindung der Eingang des ersten Schalterelements mit dem Eingang des zweiten Schalterelements sowie mit einem Mischsignaleingang, an dem ein zu mischendes Signal anlegbar ist, gekoppelt.

Gemäß dieser Ausgestaltung der Erfindung ist es vorzugsweise vorgesehen, den ersten elektrischen Widerstand und den dritten elektrischen Widerstand in gleicher Weise zu dimensionieren sowie den zweiten elektrischen Widerstand und den vierten elektrischen Widerstand gleich zu dimensionieren.

Zwischen die Eingänge der Schalterelemente und dem Mischsignaleingang kann ein weiteres Schalterelement geschaltet sein, wobei der Mischsignaleingang mit einem Steuereingang des Eingangstransistors gekoppelt ist.

Gemäß einer weiteren Ausgestaltung der Erfindung ist es vorgesehen, dass die Rückkopplungselemente derart eingereichtet sind, dass die Phasenlage der an den jeweiligen Steuereingang angelegten Signale einstellbar ist.

Ferner können die Rückkopplungselemente als frequenzbestimmende Elemente der Oszillator-/Mischerschaltung eingerichtet sein.

Der Ausdruck "frequenzbestimmendes Element" ist im Rahmen dieser Beschreibung derart zu verstehen, dass mittels eines solchen Elements die Schwingfrequenz der Oszillatorschaltung einstellbar ist.

Das erste Rückkopplungselement und das zweite Rückkopplungselement können jeweils einen Kondensator aufweisen, vorzugsweise einen in seiner Kapazität jeweils, vorzugsweise mittels einer Steuerspannung, veränderbar einstellbaren Kondensator.

Das erste Schalterelemente und/oder das zweite Schalterelement können jeweils einen Transistor aufweisen oder von einem Transistor gebildet werden.

Gemäß einer weiteren Ausgestaltung der Erfindung ist es vorgesehen, dass zumindest ein Teil der Bauelemente in CMOS-Technologie hergestellt sind.

Ausführungsbeispiele der Erfindung sind in den Figuren dargestellt und werden im Weiteren näher erläutert.

Es zeigen
- Figur 1: eine Oszillator-/Mischerschaltung gemäß einem ersten Ausführungsbeispiel der Erfindung;
- Figur 2: eine Prinzipdarstellung eines Hochfrequenz-Oszillators;
- Figur 3: eine Oszillatorschalung gemäß dem Stand der Technik;
- Figur 4: eine Grundschaltung einer Gilbertzelle gemäß dem Stand der Technik;
- Figur 5: eine Oszillator-/Mischerschaltung gemäß dem Stand der Technik;
- Figur 6: eine Oszillator-/Mischerschaltung gemäß einem zweiten Ausführungsbeispiel der Erfindung; und
- Figur 7: eine Oszillator-/Mischerschaltung gemäß einem dritten Ausführungsbeispiel der Erfindung;

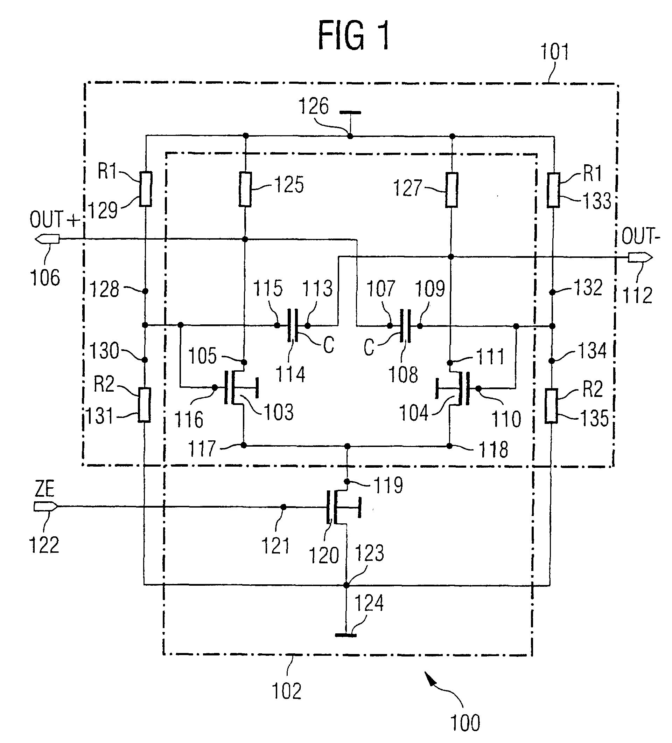

**Fig.1** zeigt eine Oszillator-/Mischerschaltung 100 gemäß einem ersten Ausführungsbeispiel der Erfindung;

Die Oszillator-/Mischerschaltung 100 weist eine Oszillatorschaltung 101 (symbolisiert mittels gestrichelter Linien in **Fig.1**) und eine Mischerschaltung 102 (symbolisiert mittels Strichpunktierung in **Fig.1**) auf.

Wie in **Fig.1** gezeigt ist, sind einige Bauelemente der Oszillator-/Mischerschaltung 100 sowohl in der Oszillatorschaltung 101 als auch in der Mischerschaltung 102 enthalten.

Die Oszillator-/Mischerschaltung 100 weist einen ersten Schalttransistor 103 sowie einen zweiten Schalttransistor 104 auf.

Der Drain-Anschluss 105 des ersten Schalttransistors 103 ist mit einem ersten Ausgang 106 der Oszillator-/Mischerschaltung 100 gekoppelt. An dem ersten Ausgang 106 wird im Mischbetrieb der Oszillator-/Mischerschaltung 100 ein erstes Ausgangssignal OUT+, welches im Abwärts-Mischbetrieb auch als erstes Zwischenfrequenzsignal OUT+ bezeichnet wird, bereitgestellt.

Ferner sind der erste Ausgang 106 und der Drain-Anschluss 105 des ersten Schalttransistors 103 als Schalterausgang des ersten Schalterelements mit einem ersten Anschluss 107 eines ersten Kondensators 108 als erstes Rückkopplungselement gekoppelt. Ein zweiter Anschluss 109 des ersten Kondensators 108 ist mit dem Gate-Anschluss 110 des zweiten Schalttransistors 104 gekoppelt.

Der Drain-Anschluss 111 des zweiten Schalttransistors 104 als Schalterausgang des zweiten Schalterelements ist mit einem zweiten Ausgang 112 der Oszillator-/Mischerschaltung 100 gekoppelt. An dem zweiten Ausgang 112 wird im Mischerbetrieb der Oszillator-/Mischerschaltung 100 ein zweites Ausgangssignal, welches im Abwärts-Mischbetrieb auch als zweites Zwischenfrequenzsignal OUT- bezeichnet wird, bereitgestellt.

Das zweite Ausgangssignal ist in seiner Phasenlage gegenüber dem ersten Ausgangssignal um 180° verschoben.

Ferner ist der Drain-Anschluss 111 des zweiten Schalttransistors 104 mit einem ersten Anschluss 113 eines zweiten Kondensators 114 als zweites Rückkopplungselement gekoppelt. Ein zweiter Anschluss 115 des zweiten Kondensators 114 ist mit dem Gate-Anschluss 116 des ersten Schalttransistors 103 gekoppelt.

Der Source-Anschluss 117 des ersten Schalttransistors 103 als Schaltereingang des ersten Schalterelements ist mit dem Source-Anschluss 118 des zweiten Schalttransistors 104 als Schaltereingang des zweiten Schalterelements gekoppelt sowie mit dem Drain-Anschluss 119 eines Eingangstransistors 120, der nicht mehr ein funktionelles Element der Oszillatorschaltung 101 jedoch ein funktionelles Element der Mischerschaltung 102 ist.

Der Gate-Anschluss 121 des Eingangstransistors 120 ist mit einem Mischsignaleingang 122 gekoppelt, an dem ein zu mischendes üblicherweise analoges Eingangssignal ZE angelegt werden kann.

Der Source-Anschluss 123 des Eingangstransistors 120 ist mit dem Masseanschluss 124 gekoppelt.

Anders ausgedrückt bedeutet dies, dass die Drain-Anschlüsse, d.h. anschaulich die Ausgänge der beiden Schalttransistoren 103, 104, kreuzweise über jeweils einen Kondensator 108 bzw. 114 an die Gate-Anschlüsse 110, 116 des jeweils anderen Schalttransistors 103, 104 rückgekoppelt sind.

Dies bedeutet anschaulich, dass die Mischerschaltung 102 im Vergleich zur Mischerschaltung gemäß dem Stand der Technik, welche eine Diode als mischendes Element aufweist, erfindungsgemäß ein Schaltmischer verwendet wird, bei dem die jeweiligen Schalttransistoren 103, 104 sich gegenphasig jeweils gegenseitig einschalten bzw. ausschalten.

Anders ausgedrückt bedeutet dies, dass für den Fall, dass der erste Schalttransistor 103 eingeschaltet ist, aufgrund der Rückkopplung über den ersten Kondensator 108 zu dem Gate-Anschluss 110 des zweiten Schalttransistors 104, der zweite Schalttransistor 104 deaktiviert ist. Für den Fall, dass der zweite Schalttransistor 104 aktiviert ist, ist aufgrund der Rückkopplung über den zweiten Kondensator 114 an den Gate-Anschluss 116 des ersten Schalttransistors, der erste Schalttransistor 103 deaktiviert ist.

Der Drain-Anschluss 105 des ersten Schalttransistors 103 ist ferner über einen ersten elektrischen Widerstand 125 mit einem Versorgungsanschluss 126, an dem die Betriebsspannung V_{DD} der Oszillator-/Mischerschaltung 100 anlegbar ist, gekoppelt.

Ebenfalls mit dem Versorgungsanschluss 126 ist der Drain-Anschluss 111 des zweiten Schalttransistors 104 über einen zweiten elektrischen Widerstand 127 gekoppelt.

Weiterhin sind der Gate-Anschluss 116 des ersten Schalttransistors sowie der zweite Anschluss 115 des zweiten Kondensators 114 mit einem ersten Anschluss 128 eines dritten elektrischen Widerstands 129 und über diesen mit dem Versorgungsanschluss 126 gekoppelt.

Ferner sind der Gate-Anschluss 116 des ersten Schalttransistors und der zweite Anschluss 115 des zweiten Kondensators 114 über einen ersten Anschluss 130 eines vierten elektrischen Widerstands 131 und über diesen mit dem Masseanschluss 124 gekoppelt.

Der Gate-Anschluss 110 des zweiten Schalttransistors 104 und der zweite Anschluss 109 des ersten Kondensators 108 sind mit einem ersten Anschluss 132 eines fünften elektrischen Widerstands 133 und über diesen mit dem Versorgungsanschluss 126 gekoppelt.

Ferner sind der Gate-Anschluss 110 des zweiten Schalttransistors 104 und der zweite Anschluss 109 des ersten Kondensators 108 mit einem ersten Anschluss 134 eines sechsten elektrischen Widerstands 135 und über diesen mit dem Masseanschluss 124 gekoppelt.

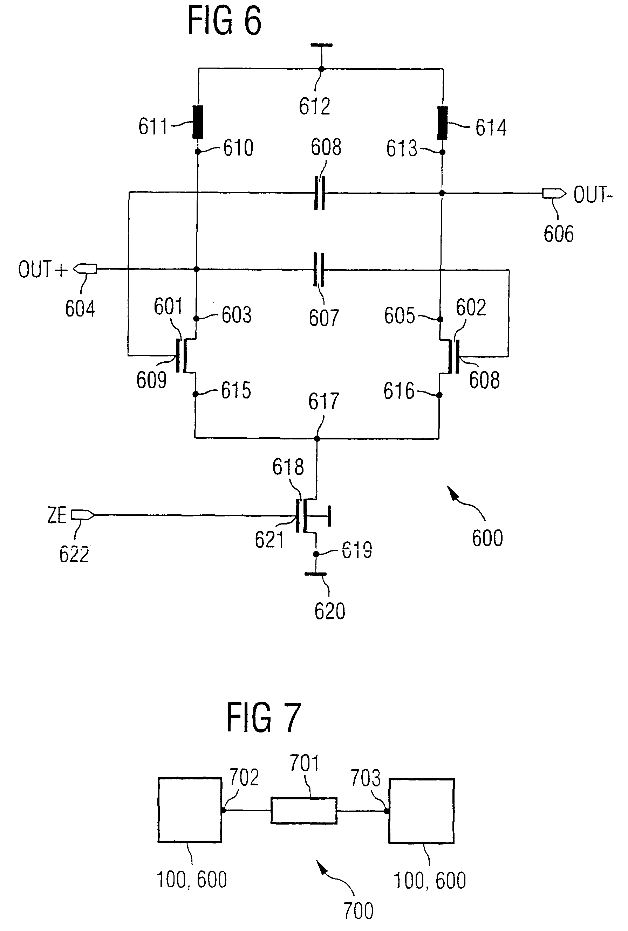

**Fig.6** zeigt eine Oszillator-/Mischerschaltung 600 gemäß einem zweiten Ausführungsbeispiel der Erfindung.

Gemäß dem zweiten Ausführungsbeispiel der Erfindung ist die Oszillatorschaltung als LC-Oszillatorschaltung eingerichtet.

Die Oszillator-/Mischerschaltung 600 weist einen ersten Schalttransistor 601 und einen zweiten Schalttransistor 602 auf.

Der Drain-Anschluss 603 des ersten Schalttransistors 601 ist mit einem ersten Ausgang 604 der Oszillator-/Mischerschaltung 600 gekoppelt und der Drain-Anschluss 605 des zweiten Schalttransistors 602 ist mit einem zweiten Ausgang 606 der Oszillator-/Mischerschaltung 600 gekoppelt.

Ferner ist der Drain-Anschluss 603 des ersten Schalttransistors 601 über einen ersten Kondensator 607 als erstes Rückkopplungselement mit dem Gate-Anschluss 608 des zweiten Schalttransistors 602 gekoppelt und der Drain-Anschluss 605 des zweiten Schalttransistors 602 über einen zweiten Kondensator 608 als zweites Rückkopplungselement mit dem Gate-Anschluss 609 des ersten Schalttransistors 601.

Auf diese Weise wird wiederum eine kreuzweise Rückkopplung der jeweiligen Ausgänge der Schalttransistoren als Schalterelemente der Oszillator-/Mischerschaltung 600 auf die jeweiligen Steuerungseingänge, d.h. die Gate-Anschlüsse des jeweiligen anderen Schalttransistors erreicht.

Der Drain-Anschluss 603 des ersten Schalttransistors 601 ist ferner mit einem ersten Anschluss 610 einer ersten Induktivität 611 gekoppelt und darüber mit einem Versorgungsanschluss 612 der Oszillator-/Mischerschaltung 600.

Der Drain-Anschluss 605 des zweiten Schalttransistors 602 ist weiterhin mit einem ersten Anschluss 613 einer zweiten Induktivität 614 gekoppelt und darüber ebenfalls mit dem Versorgungsanschluss 612.

Ferner sind der Source-Anschluss 615 des ersten Schalttransistors 601 und der Source-Anschluss 616 des zweiten Schalttransistors 602 miteinander sowie mit einem Drain-Anschluss 617 eines Eingangstransistors 618 gekoppelt, dessen Source-Anschluss 619 mit dem Masseanschluss 620 gekoppelt ist.

Der Source-Anschluss 621 des Eingangstransistors 619 ist mit einem Mischsignaleingang 622 der Oszillator-/Mischerschaltung 600 gekoppelt.

Die Kondensatoren der oben beschriebenen Rückkopplungselemente sowohl der Oszillator-/Mischerschaltung 100 gemäß dem ersten Ausführungsbeispiel als auch der Oszillator-/Mischerschaltung 600 gemäß dem zweiten Ausführungsbeispiel sind derart eingerichtet, dass jeweils eine Phasenverschiebung von 180° der jeweils an den Gate-Anschlüssen der Schalttransistoren anliegenden elektrischen analogen Signale gewährleistet ist.

**Fig.7** zeigt als drittes Ausführungsbeispiel zwei in Serie geschaltete Mischer-/Oszillatorschaltungen gemäß dem ersten Ausführungsbeispiel oder gemäß dem zweiten Ausführungsbeispiel, die über ein Phasenschieberelement 701, welches derart eingerichtet ist, dass das die Phase eines an einem Ausgang der ersten Oszillator-/Mischerschaltung anliegenden Ausgangssignals 702 gegenüber dem an dem Eingang der zweiten Oszillator-/Mischerschaltung anliegenden Eingangssignals 703 um 90° verschoben ist.

Auf diese Weise wird eine insgesamt vier Ausgangssignale bereitstellende Oszillator-/Mischerschaltung 700 angegeben, deren Ausgangssignale jeweils um 90° voneinander verschoben sind.

In beiden oben beschriebenen Ausführungsbeispielen sind die Bauelemente in CMOS-Technologie hergestellt, d.h. insbesondere die verwendeten Transistoren sind CMOS-Feldeffekttransistoren.

Durch die oben beschriebenen Realisierungen sind somit die Mischerschaltung und die Oszillatorschaltung anschaulich keine voneinander räumlich getrennten Schaltungen mehr, es werden vielmehr zum großen Teil dieselben Bauelemente für sowohl die Mischerschaltung als auch für die Oszillatorschaltung verwendet.

Treten somit in der Oszillator-/Mischerschaltung Bauelemente-Toleranzen auf, so wirken sich diese auf sowohl die Funktion der Mischerschaltung als auch die der Oszillatorschaltung in gleicher Weise aus, die Mischerschaltung und die Oszillatorschaltung bleiben somit ideal aufeinander abgestimmt.

Aufgrund der Einsparung der in einer Oszillator-/Mischerschaltung gemäß dem Stand der Technik erforderlichen Verbindungsleitungen (vgl. **Fig.5**, Verbindungsleitungen 501, 502) zwischen der Oszillatorschaltung und der Mischerschaltung eignet sich die erfindungsgemäße Oszillator-/Mischerschaltung insbesondere für den Einsatz in der Höchstfrequenztechnik, insbesondere als Sender und/oder Empfänger. Ein geeigneter Frequenzbereich zum Betreiben der erfindungsgemäßen Oszillator-/Mischerschaltung liegt vorzugsweise in der Größenordnung von einem bis einigen 10 GHz, so dass die Oszillator-/Mischerschaltung für drahtlose Funkübertragung, beispielsweise als Mobilfunksender bzw. Mobilfunkempfänger, als Radarsender bzw. Radarempfänger oder als Empfänger für ein Global Positioning System (GPS) geeignet eingesetzt werden kann.

Anschaulich kann die Erfindung darin gesehen werden, dass eine Oszillatorschaltungseinheit und eine Mischerschaltungseinheit teilweise dieselben Bauelemente aufweisen, um ihre jeweilige Funktion zu erfüllen. Die Mischerschaltung weist mindestens zwei Schalterelemente auf. Deren Ausgänge sind jeweils kreuzweise an die Steuereingange des jeweils anderen Schalterelements über jeweils ein Rückkoppelungselement gekoppelt ist. Das Rückkoppelungselement ist jeweils derart eingerichtet, dass zusätzlich ein Oszillatorbetrieb der Oszillator-/Mischerschaltung ermöglicht ist.

Es ist in diesem Zusammenhang anzumerken, dass die Oszillator-/Mischerschaltung als Aufwärtsmischer oder auch als Abwärtsmischer eingerichtet sein kann.

## Patentansprüche

1. Oszillator-/Mischerschaltung
• mit einer Oszillatorschaltung,
• mit einer Mischerschaltung,
• bei der die Oszillatorschaltung und die Mischerschaltung teilweise dieselben Bauelemente aufweisen,
• bei der die Mischerschaltung mindestens ein erstes Schalterelement und ein zweites Schalterelement aufweist, **dadurch gekennzeichnet:**
- **dass** ein Ausgang des ersten Schalterelements über ein erstes Rückkopplungselement mit einem Steuereingang des zweiten Schalterelements gekoppelt ist,
- **dass** ein Ausgang des zweiten Schalterelements über ein zweites Rückkopplungselement mit einem Steuereingang des ersten Schalterelements gekoppelt ist, und
- **dass** die Rückkopplungselemente derart eingerichtet sind, dass ein Oszillatorbetrieb der Oszillator-/Mischerschaltung ermöglicht ist.

2. Oszillator-/Mischerschaltung nach Anspruch 1, bei der die Oszillatorschaltung als LC-Oszillatorschaltung eingerichtet ist.

3. Oszillator-/Mischerschaltung nach Anspruch 2,
• bei der an den Ausgang des ersten Schalterelements und an den Ausgang des zweiten Schalterelements jeweils eine Induktivität gekoppelt ist, und
• bei der der Eingang des ersten Schalterelements mit dem Eingang des zweiten Schalterelements sowie mit einem Mischsignaleingang, an den ein zu mischendes Signal anlegbar ist, gekoppelt ist.

4. Oszillator-/Mischerschaltung nach Anspruch 3, bei der zwischen die Eingänge der Schalterelemente und den Mischsignaleingang ein Eingangstransistor geschaltet ist, wobei der Mischsignaleingang mit einem Steuereingang des Eingangstransistors gekoppelt ist.

5. Oszillator-/Mischerschaltung nach Anspruch 1 oder 2, bei der die Oszillatorschaltung als RC-Oszillatorschaltung eingerichtet ist.

6. Oszillator-/Mischerschaltung nach Anspruch 5,
• mit einem ersten elektrischen Widerstand, der zwischen den Steuereingang des ersten Schalterelements und einem Versorgungsanschluss geschaltet ist, an den eine Betriebsspannung der Oszillator-/Mischerschaltung anlegbar ist,
• mit einem zweiten elektrischen Widerstand, der zwischen den Steuereingang des ersten Schalterelements und dem Eingang des ersten Schalterelements geschaltet ist,
• mit einem dritten elektrischen Widerstand, der zwischen den Steuereingang des zweiten Schalterelements und dem Versorgungsanschluss geschaltet ist,
• mit einem vierten elektrischen Widerstand, der zwischen den Steuereingang des zweiten Schalterelements und dem Eingang des zweiten Schalterelements geschaltet ist, und
• bei der der Eingang des ersten Schalterelements mit dem Eingang des zweiten Schalterelements sowie mit einem Mischsignaleingang, an den ein zu mischendes Signal anlegbar ist, gekoppelt ist.

7. Oszillator-/Mischerschaltung nach Anspruch 6, bei der zwischen die Eingänge der Schalterelemente und dem Mischsignaleingang ein weiteres Schalterelement geschaltet ist, wobei der Mischsignaleingang mit einem Steuereingang des Eingangstransistors gekoppelt ist.

8. Oszillator-/Mischerschaltung nach einem der Ansprüche 1 bis 7,
bei der die Rückkopplungselemente derart eingerichtet sind, dass die Phasenlage der an den jeweiligen Steuereingängen anliegenden Signale einstellbar ist.

9. Oszillator-/Mischerschaltung nach einem der Ansprüche 1 bis 8, bei der die Rückkopplungselemente als frequenzbestimmende Elemente eingerichtet sind.

10. Oszillator-/Mischerschaltung nach einem der Ansprüche 1 bis 9, bei der das erste Rückkopplungselement und das zweite Rückkopplungselement einen Kondensator aufweist.

11. Oszillator-/Mischerschaltung nach einem der Ansprüche 1 bis 10,
• bei der das erste Schalterelement einen Transistor aufweist, und
• bei der das zweite Schalterelement einen weiteren Transistor aufweist.

12. Oszillator-/Mischerschaltung nach einem der Ansprüche 1 bis 11,
bei der zumindest ein Teil der Bauelemente in CMOS-Technologie hergestellt sind.

## Claims

1. An oscillator/mixer circuit
• having an oscillator circuit,
• having a mixer circuit
• in which the oscillator circuit and the mixer circuit have the same components to some extent,
• in which the mixer circuit has at least a first switch element and a second switch element,
**characterized in that**
- an output of the first switch element is coupled to a control input of the second switch element via a first feedback element,
- an output of the second switch element is coupled to a control input of the first switch element via a second feedback element, and
- the feedback elements are set up such that oscillator operation of the oscillator/mixer circuit is made possible.

2. The oscillator/mixer circuit as claimed in claim 1, in which the oscillator circuit is set up as an LC oscillator circuit.

3. The oscillator/mixer circuit as claimed in claim 2,
• in which a respective inductor is coupled to the output of the first switch element and to the output of the second switch element, and
• in which the input of the first switch element is coupled to the input of the second switch element and to a mixing signal input to which a signal to be mixed can be applied.

4. The oscillator/mixer circuit as claimed in claim 3,
in which an input transistor is connected between the inputs of the switch elements and the mixing signal input, with the mixing signal input being coupled to a control input of the input transistor.

5. The oscillator/mixer circuit as claimed in claim 1 or 2,
in which the oscillator circuit is set up as an RC oscillator circuit.

6. The oscillator/mixer circuit as claimed in claim 5,
• having a first electrical resistor, which is connected between the control input of the first switch element and a supply connection to which an operating voltage for the oscillator/mixer circuit can be applied,
• having a second electrical resistor, which is connected between the control input of the first switch element and the input of the first switch element,
• having a third electrical resistor, which is connected between the control input of the second switch element and the supply connection,
• having a fourth electrical resistor, which is connected between the control input of the second switch element and the input of the second switch element, and
• in which the input of the first switch element is coupled to the input of the second switch element and also to a mixing signal input to which a signal to be mixed can be applied.

7. The oscillator/mixer circuit as claimed in claim 6,
in which a further switch element is connected between the inputs of the switch elements and the mixing signal input, with the mixing signal input being coupled to a control input of the input transistor.

8. The oscillator/mixer circuit as claimed in one of claims 1 to 7,
in which the feedback elements are set up such that the phase angle of the signals applied to the respective control inputs can be set.

9. The oscillator/mixer circuit as claimed in one of claims 1 to 8,
in which the feedback elements are set up as frequency determining elements.

10. The oscillator/mixer circuit as claimed in one of claims 1 to 9,
in which the first feedback element and the second feedback element has a capacitor.

11. The oscillator/mixer circuit as claimed in one of claims 1 to 10,
• in which the first switch element has a transistor, and
• in which the second switch element has a further transistor.

12. The oscillator/mixer circuit as claimed in one of claims 1 to 11,
in which at least some of the components are produced using CMOS technology.

## Revendications

1. Circuit oscillateur/mélangeur, comportant
• un circuit oscillateur,
• un circuit mélangeur,
• dans lequel le circuit oscillateur et le circuit mélangeur possèdent en partie les mêmes composants,
• dans lequel le circuit mélangeur comporte au moins un premier élément commutateur et un second élément commutateur,
**caractérisé en ce**
- **qu'**une sortie du premier élément commutateur est couplée à une entrée de commande du second élément commutateur par l'intermédiaire d'un premier circuit de rétroaction,
- **qu'**une sortie du second élément commutateur est couplée à une entrée de commande du premier élément commutateur au moyen d'un second élément de rétroaction, et
- **que** les éléments de rétroaction sont agencés de telle sorte qu'un fonctionnement en oscillateur du circuit oscillateur/mélangeur est possible.

2. Circuit oscillateur/mélangeur selon la revendication 2, dans lequel le circuit oscillateur est agencé sous la forme d'un circuit oscillateur LC.

3. Circuit oscillateur/mélangeur selon la revendication 2,
• dans lequel une inductance est couplée respectivement à la sortie du premier élément commutateur et à la sortie du second élément commutateur, et
• dans lequel l'entrée du premier élément commutateur est couplée à l'entrée du second élément commutateur ainsi qu'à une entrée du signal de mélange, à laquelle est appliqué un signal à mélanger.

4. Circuit oscillateur/mélangeur selon la revendication 3, dans lequel un transistor d'entrée est branché entre les entrées des éléments commutateurs et l'entrée du signal de mélange,
l'entrée du signal de mélange étant couplée à une entrée de commande du transistor d'entrée.

5. Circuit oscillateur/mélangeur selon la revendication 1 ou 2, dans lequel le circuit oscillateur est agencé sous la forme d'un circuit oscillateur RC.

6. Circuit oscillateur/mélangeur selon la revendication 5, comportant
• une première résistance électrique, qui est branchée entre l'entrée de commande du premier élément commutateur et une borne d'alimentation, à laquelle peut être appliquée une tension de fonctionnement du circuit oscillateur/mélangeur,
• une seconde résistance électrique, qui est branchée entre l'entrée de commande du premier élément commutateur et l'entrée du premier élément commutateur,
• comportant une troisième résistance électrique, qui est branchée entre l'entrée de commande du second élément commutateur et la borne d'alimentation,
• comportant une quatrième résistance électrique, qui est branchée entre l'entrée de commande du second élément commutateur et l'entrée du second élément commutateur, et
• dans lequel l'entrée du premier élément commutateur est couplée à l'entrée du second élément commutateur ainsi qu'à une entrée du signal de mélange, à laquelle peut être appliqué un signal à mélanger.

7. Circuit oscillateur/mélangeur selon la revendication 6, dans lequel un autre élément commutateur est branché entre les entrées des éléments commutateurs et l'entrée du signal de mélange, l'entrée du signal de mélange étant couplée à une entrée de commande du transistor d'entrée.

8. Circuit oscillateur/mélangeur selon l'une des revendications 1 à 7, dans lequel les éléments de rétroaction sont agencés de telle sorte que la position de phase des signaux appliqués aux entrées de commande respectives est réglable.

9. Circuit oscillateur/mélangeur selon l'une des revendications 1 à 8, dans lequel les éléments de rétroaction sont agencés sous la forme d'éléments déterminant la fréquence.

10. Circuit oscillateur/mélangeur selon l'une des revendications 1 à 9, dans lequel le premier élément de rétroaction et le second élément de rétroaction comportent un condensateur.

11. Circuit oscillateur/mélangeur selon l'une des revendications 1 à 10,
• dans lequel le premier élément commutateur comporte un transistor, et
• dans lequel le second élément commutateur comporte un autre transistor.

12. Circuit oscillateur/mélangeur selon l'une des revendications 1 à 11, dans lequel au moins une partie des composants sont réalisés selon la technologie CMOS.
